# EUROPÄISCHE PATENTSCHRIFT

(11) **EP 0 244 634 B1**
(45) Veröffentlichungstag und Bekanntmachung des Hinweises auf die Patenterteilung: **26.07.1995**
(21) Anmeldenummer: 87104846.8
(22) Anmeldetag: 02.04.1987
(51) Int. Cl.: H03H 7/24, H01C 10/04, H01C 10/26, H01C 10/20

(54) **Verstellbares Dämpfungsglied**
Variable attenuator
Atténuateur variable

(30) Priorität: 04.04.1986 DE 8609032 U
(43) Veröffentlichungstag der Anmeldung: 11.11.1987
(73) Patentinhaber: AB Elektronik GmbH, D-59368 Werne (DE)
(72) Erfinder: Grabsch, August Friedrich, D-4712 Werne (DE)
(74) Vertreter: Hoffmeister, Helmut, Dr. Dipl.-Phys.

(56) Entgegenhaltungen:
- FR-A- 2 111 961
- GB-A- 886 488

## Beschreibung

Die Erfindung betrifft ein verstellbares Dämpfungsglied mit einem vorgegebenen eingangs- und ausgangsseitig konstanten Wellenwiderstand, mit dem die Durchgangsdämpfung stetig zwischen einem Anfangs- und Endwert einstellbar ist, mit wenigstens zwei gleichzeitig verstellbaren, ohmschen Widerständen, die in unsymmetrischer oder symmetrischer π-, T- oder überbrückter T-Schaltung angeordnet sind.

Derartige Dämpfungsglieder dienen zur Entziehung eines Teiles der Wellenenergie elektromagnetischer Wellen auf Leitungen im Hochfrequenzbereich. Es handelt sich um veränderbare Spannungsteiler mit definiertem reellem Ein- und Ausgangswiderstand. Sie bestehen aus Widerständen in symmetrischer oder unsymmetrischer π, T- oder überbrückter T-Schaltung.

Ein verstellbares Dämpfungsglied der eingang genannten Art ist aus der GB-A-886 488 bekannt. Das bekannte Dämpfungsglied (vgl. Ausführungsform gem. Fig. 3. der GB-A-886.488) besitzt einen flachen Drehkörper, auf dem im Schleifbereich von Schleifkontakten wenigstens zwei flache Widerstandsbeläge aufliegen, die in einen Bereich hohen Widerstand pro Längeneinheit und in einen Bereich vernachlässigbar geringen Widerstands pro Längeneinheit aufgeteilt sind.

Die Schleifkontakte liegen auf den Widerstandbelägen auf; der Drehkörper ist gegenüber den Schleifkontakten entsprechend einem zwischen Φₒ und Φₘₐₓ liegenden Drehwinkel Φ mechanisch verdrehbar. Entsprechend dem Drehwinkel des Drehkörpers gegenüber dem Schleifkontakt besitzt die Widerstandsstrecke einen dem Drehwinkel Φ proportionalen Widerstandswert.

Nachteilig ist, daß die Wegstrecke für den elektrischen Strom auf den Widerstandsbahnen bei dem Dämpfungsglied gemäß Stand der Technik für verschiedene Schleifkontaktstellungen - entsprechend verschiedenen Durchgangsdämpfungen - unterschiedlich und damit nicht symmetrisch ist. Die Rücklaufdämpfung ist daher stellungsabhängig.

Bekannt ist weiterhin aus der FR-A-2 111 961 ein verstellbares Dämpfungsglied. Es besteht aus einer Rotorplatte mit Schichten aus Widerstands- und leitendem Material. Die Rotorplatte besitzt in einer zentralen Ausnehmung eine Welle, um sich in Bezug auf eine Startorplatte zu drehen. Auf der Rotorplatte ist eine bogenförmige Widerstandsschicht in Form eines Streifens vorgesehen. Davor liegt im Bereich der zentralen Öffnung eine leitende Schicht. Zwischen beiden Schichten sind speichenförmig Widerstandssegmente angeordnet. Weiterhin ist auf dem Rotorelement ein bogenförmiger leitender Streifen aufgebracht, dessen Ende die Widerstandsschicht überlappt. Bei Drehung des Rotorelementes werden so die entsprechenden Widerstandsbereiche abgegriffen,während alle NebenschluAwiderstände und der Abschlußwiderstand ständig einseitig miteinander verbunden und über die Kontakte mit dem Massepotential kontaktiert sind. Der Wellenwiderstand der Anordnung stimmt daher nur ein seitig mit dem Wellenwiderstand der Eingangsleitung überein, während die andere Seite bezüglich des Eingangswiderstandes nicht symmetrisch ist.

Es stellt sich demnach die Aufgabe, ein Dämpfungsglied anzugeben, bei dem die Dämpfung stufenlos einstellbar ist, das in einer kompakten Form als passiver, symmetrischer Vierpol herstellbar ist und bei dem die Weglänge der elektromagnetischen Welle für alle Positionen des Schleifkontaktes zur Widerstandsstrecke konstant und so klein wie möglich ist.

Erfindungsgemäß wird die Aufgabe durch ein Dämpfungsglied gemäß Anspruch 1 gelöst.

Unter Drehkörpern werden insbesondere Trommeln, Scheiben oder Scheibenanordnungen verstanden, wobei wenigstens eine der folgenden Flächen mit einem Widerstandsbelag versehen ist: die Stirnseiten, die Innenmantelfläche, die Außenmantelfläche, die Peripherie. Unter Drehkörpern sollen alle geeigneten Körper verstanden werden, auf denen Schleifkontakte in der beschriebenen Weise während des Verdrehens des Drehkörpers aufliegen können. Üblicherweise handelt es sich hierbei um die bereits genannten Trommeln oder Scheibenanordnungen. Es sind jedoch auch Gebilde denkbar, die als Ausschnitte (Segmente) vorstehender Elemente darstellbar sind. Darüber hinaus ließen sich auch polygonale Prismen, Zylinder mit ellipsoiden Grundrissen und dergleichen denken.

Erfindungswesentlich bei dem Dämpfungsglied gemäß Erfindung ist, daß belegbare Flächen vorhanden sind. Für den Fall, daß bei einer Trommel ein Innenmantel belegt werden soll, wird eine Hohltrommel oder ein Hohlzylinder gewählt. Eine, zwei oder mehr dieser Flächen sind jeweils durch eine geeignete, vorzugsweise gleichbreite Widerstandsschicht oder einen Widerstandsbelag belegt. Anstelle einer Trommel kann auch eine Scheibenanordnung treten, bei der zwischen trommel- oder lamellenartig angeordneten, parallel gestellten Scheiben Luft oder ein anderes Dielektrikum vorhanden ist.

Mit dem Dämpfungsglied kann die Durchgangsdämpfung entweder stufenlos, oder aber auch abgestuft zwischen einem Anfangs- und Endwert eingestellt werden.

Ein für das Dämpfungsglied geeigneter Drehkörper besteht aus einem elektrisch isolierenden Material, beispielsweise keramischem Material, auf dessen Trägerfläche die Widerstandsschichten durch Druck, Lackieren, Galvanotechnik und ähnliche, an sich bekannte Techniken aufgebracht sind. Bei den Widerstandstechniken handelt es sich um graphit- oder metallhaltige Schichten oder andere, "exotische" Kunststoffmaterialien, wie diese an sich bekannt sind oder in angepaßter Weise zu entwickeln sind. Es ist auch möglich, zunächst eine relativ dicke Materialschicht aufzubringen und diese entsprechend der gewünschten Widerstandsabhängigkeit vom Drehwinkel Φ mehr oder weniger abzutragen. Die Schichten können dabei kontinuierlich verändert sein; es ist jedoch auch möglich, eine Quasi-Kontinuität dadurch zu erzeugen, daß strahlen- oder strichartig sehr viele, bis hin zu quasi infinitesimal viele Widerstandsschichten nebeneinandergelegt werden.

Beispielsweise kann ein Widerstandsbelag in Form eines in Radiusrichtung gleichbreiten Kreissegmentes auf eine Stirnseite der Trommel oder der Scheibe aufgebracht sein, wobei der ohmsche Widerstand abhängig vom Drehwinkel Φ auf der in Radiusrichtung liegenden Widerstandsstrecke ist.

Eine andere Möglichkeit ist, daß die Trommel auf ihrem Außen- oder Innenmantel wenigstens einen streifenförmigen Widerstandsbelag trägt, auf dem bzw. auf denen zwei Schleifkontakte in konstantem peripheren bzw. epipheren bzw. axialen Abstand aufliegen, wobei der Widerstandsbelag ebenfalls so beschaffen ist, daß der ohmsche Widerstand pro Streckeneinheit in peripherem bzw. epipherem bzw. axialem Abstand abhängig vom Drehwinkel Φ ist.

Es können auch Widerstandsbeläge so aufgebracht werden, daß sie auf einer gemeinsamen Fläche angebracht sind und sich dabei im Randbereich kontaktieren.

Die Schleifkontakte können an den Enden von Fahnen oder Kontaktstiften angebracht sein. Es ist auch möglich, daß bei Vorhandensein eines Wellenleiters in Streifenleitertechnik die Schleifkontakte an den Enden solcher Wellenleiter angebracht sind.

Das Dämpfungsglied wird vorzugsweise in ein Gehäuse eingefaßt. Die Trommel z. B. ist mit einem Zahnkranz verbunden, in den eine mit einem Schneckengang versehene Drehspindel eingreift, so daß eine exakte Drehbewegung möglich ist. In das Gehäuse, das vorzugsweise aus Kunststoff besteht, können die Trägerkörper der Schleifkontakte eingebracht und gehalten sein. Weiterhin ist möglich, die Gehäusewandungen mit Öffnungen zu versehen, so daß ein oder beide Achsstummel der Trommel in den Öffnungen drehbar gehalten sind. Zur Erhöhung des Schirmungsmaßes kann das Gehäuse mit einer metallisch leitfähigen Oberfläche versehen werden.

Die dem Dämpfungsglied zukommenden Werte für die ohmschen Widerstände sind nach Aufgabenstellung, Größe des Dämpfungsgliedes, Kurzschlußfestigkeit und ähnlichen Bedingungen weitgehend variabel. Ein typisches Beispiel verwendet eine Widerstandsschicht auf der Stirnseite, bei denen die Widerstandswerte zwischen ca. 10 und 40 kOhm variieren; die Widerstandswerte auf den Mantelflächen variieren zwischen ca. 10 mOhm und 600 Ohm, entsprechend dem geforderten Wellenwiderstand und der maximalen Durchlaßdämpfung.

Vorteil bei allen vorgenannten und noch zu beschreibenden Ausführungsformen ist, daß die Fortpflanzungsrichtung der elektromagnetischen Welle auf den Widerstandsschichten zwischen den Schleifkontakten sowohl parallel als auch senkrecht zur Bewegungsrichtung des Trägerkopfes verlaufen und entsprechend die Dämpfung erfolgt. Die Weglänge der elektromagnetischen Welle auf dem Widerstandsbelag des Trägerkörpers ist minimal und für alle Positionen des Trägerkörpers konstant.

Ausführungsbeispiele der Erfindung sind in der Zeichnung dargestellt. Die Figuren der Zeichnung zeigen im einzelnen:
- Figuren 1 und 2: ein Dämpfungsglied in Seitenansicht bzw. Vorderansicht bei geöffnetem Gehäuse (erste Ausführungsform);
- Figur 3: ein Ersatzschaltbild für die Ausführungsform gemäß den Figuren 1 und 2;
- Figuren 4 und 5: eine andere Ausführungsform mit drei Widerstandselementen in Seitenansicht bzw. Vorderansicht bei geöffnetem Gehäuse;
- Figur 6: ein Ersatzschaltbild der Vorrichtung gemäß den Figuren 4 und 5;
- Figur 7 und 8: eine weitere Ausführungsform eines Dämpfungsgliedes in Seitenansicht bzw. Vorderansicht;
- Figuren 9 bis 11: eine andere Ausführungsform eines Dämpfungsgliedes in geschlossener und auseinandergezogener Darstellung.
- Figur 12: ein Detail für eine weitere Ausführungsform.

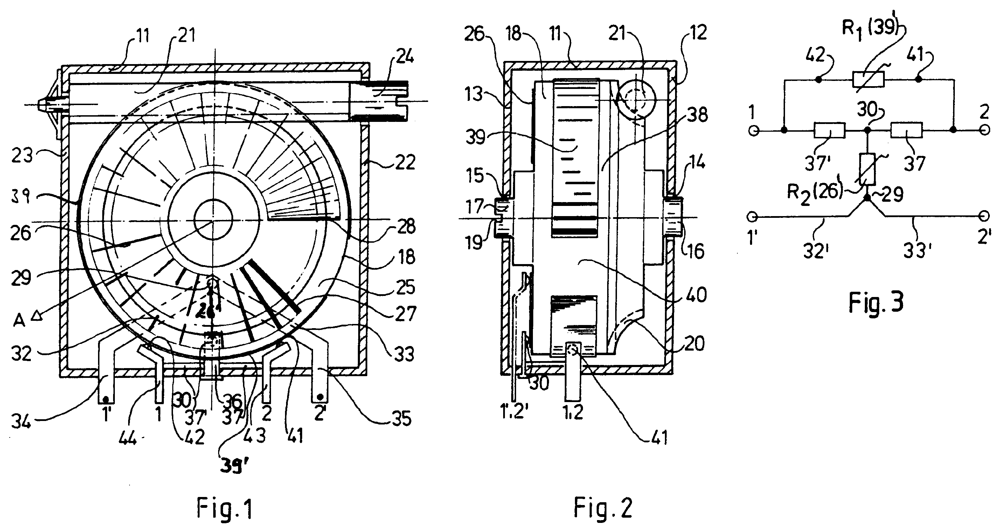

In den Figuren 1 und 2 ist ein Dämpfungsglied in einer ersten Ausführungsform dargestellt. Das Dämpfungsglied ist in ein Gehäuse 11 eingefaßt, das äußerlich die Form eines Quaders hat. Typische Abmessungen dieses Quaders sind 30 x 30 x 15 mm. Diese Maßangaben dienen lediglich zur Erläuterung und sind nicht einschränkend zu verstehen. Die Vorder- und Rückwand 12 bzw. 13 des Gehäuses 11 sind mit gegenüberliegenden Bohrungen 14, 15 versehen, in denen Achsstummel 16, 17 einer aus isolierendem Material hergestellten Trommel 18 rotierbar eingelassen sind. Dabei ist einer der Achsstummel (17) mit einem Schlitz 19 versehen, so daß ein Drehmoment auf die Achse der Trommel 18 ausgeübt werden kann. Die Trommel 18 hat im wesentlichen eine zylindrische Form. An ihrer zur Vorderwand 12 zeigenden Seite ist sie mit einem Zahnkranz 20 versehen, in den eine mit einem Schneckengang versehene Drehspindel 21 eingreift. Die Drehspindel 21 ist ebenfalls in zwei Gehäusewänden 22, 23 gelagert. Sie ragt mit einem Verstellzapfen 24 aus dem Gehäuse heraus und ist mit einem Schlitz versehen, so daß ein Drehmoment auf sie ausgeübt werden kann. Durch das Schneckengetriebe 20, 21 ist die Trommel 18 von einer Nullage (Drehwinkel φ = 0) bis zu einer Maximumlage (φ = φₘₐₓ) verstellbar. Es sind hierzu noch Anschläge an der Trommel 18 vorgesehen, die aus Vereinfachungsgründen nicht dargestellt sind.

Die in dem Gehäuse 11 drehbare Trommel 18 trägt zur Herstellung von Widerstandsstrecken auf ihrer Stirnseite 25 eine Widerstandsbelag 26 in Form eines in Radiusrichtung (A) gleichbreiten Kreissegmentes. Dieser Widerstandsbelag 26 ist derart beschaffen, daß in Radiusrichtung A der ohmsche Widerstand einer Widerstandsstrecke 26′ zwischen zwei auf dem Widerstandsbelag liegenden Kontakten bei verschiedenen Stellungen der Trommel verschieden ist, und zwar abhängig vom Drehwinkel φ ist. Bezogen auf die spezielle Ausführungsform gemäß Figur 1 ist demnach der größte Widerstand zu Beginn der Widerstandsschicht (bei 27) und der kleinste am Ende der Widerstandsschicht (bei 28).

Dementsprechend sind Schleifkontakte 29 und 30 im Bereich des Innen- und Außenrandes des Widerstandsbelages 26, diesen kontaktierend, angeordnet. Im vorliegenden Falle vereinen sich im Schleifkontakt 29 zwei Leiterbrücken 32, 33, die von den leitenden Kontaktträgern 34, 35 getragen sind, die wiederum an der Außenseite des Gehäuses Lötfahnen bilden und im Gehäuse gehalten sind. Der Schleifkontakt 30 ist ebenfalls im Gehäuse über einen Kontaktträger 36 verankert gehalten. Die Widerstandsstrecke zwischen den beiden Schleifkontakten 29, 30 liegt demnach genau in radialer Richtung und hat immer dieselbe Länge.

Weiterhin ist auf dem Außenmantel 38 der Trommel 18 eine weiterer Widerstandsbelag 39 aufgebracht, und zwar in Form eines außenliegenden, bei 40 unterbrochenen Mantels. Der Widerstandsbelag 39 besteht aus einem aufliegenden, gleichbreiten Streifen, der derart beschaffen ist, daß der ohmsche Widerstand pro Streckeneinheit in peripherem Abstand kontinuierlich veränderlich ist, und zwar abhängig vom Drehwinkel φ. Damit ergeben sich unterschiedliche Widerstände entlang der Peripherie. Die Widerstände werden abgegriffen durch zwei Schleifkontakte 41, 42, die wiederum endständig an entsprechenden Kontaktträgern 43, 44 befestigt sind. Die Schleifkontakte berühren die Außenseite des Widerstandsbelages 39, gegebenenfalls in versetzter Anordnung, wie dies aus den Figuren 1 und 2 ersichtlich ist. Die Widerstandsstrecke 39′ zwischen den beiden Kontakten 41 und 42 ist unabhängig von der Stellung der Trommel immer gleichlang.

Die Kontaktträger 43, 44 sind über je einen Schichtwiderstand 37, 37′ mit dem Kontaktträger 36 verbunden.

In der Figur 1 sind die Anschlußpunkte mit 1, 2, 1′, 2′, 30 bezeichnet. Diese Punkte finden sich wieder in dem Ersatzschaltbild gemäß Figur 3. Es ist ersichtlich, daß der Widerstand R₁ der Widerstandsstrecke 39′ zuzuordnen ist, während der Widerstand R₂ der Widerstandsstrecke 26′ zugeordnet ist. Aus der Betrachtung der mechanischen Teile gemäß Figur 1 und 2 und des Ersatzschaltbildes gemäß Figur 3 ist ersichtlich, daß die Widerstände R₁ und R₂ gleichlaufend oder gegenläufig verstellt werden können, wenn die Widerstandsbeläge 26 bzw. 39 mit dem Drehwinkel proportional oder umgekehrt proportional im Widerstand ansteigen.

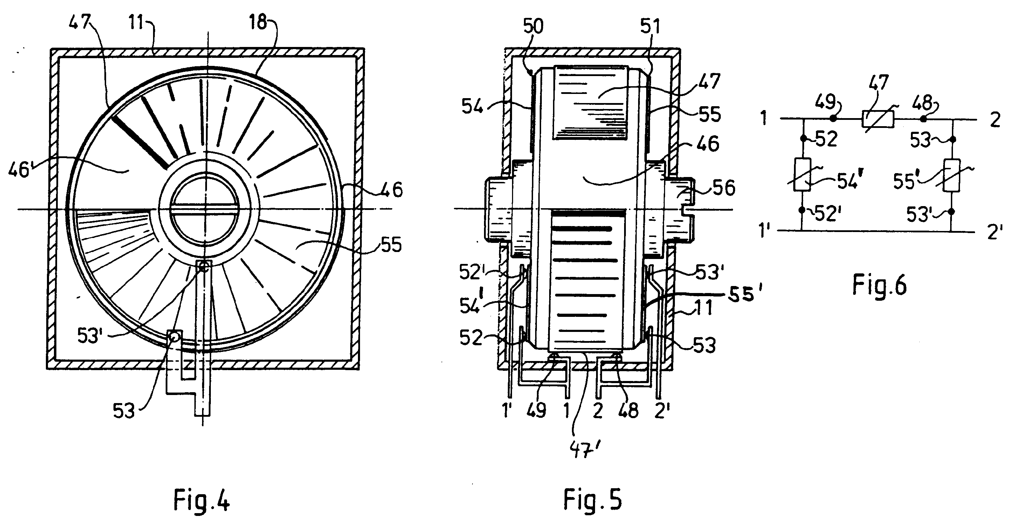

Eine weitere Ausführungsform eines Dämpfungsgliedes zeigen die Figuren 4 und 5. Bei dieser Ausführungsform ist die Trommel 18 für eine π-Schaltung angelegt. Der Außenmantel der Trommel 18 trägt einen Widerstandsbelag 47 in Form eines Streifens, der den größten Teil des Umfanges bedeckt, aber eine Lücke 46 aufweist. Der Widerstandsbelag 47 wird in dem unteren Bereich des Gehäuses 11 kontaktiert durch zwei Schleifkontakte 48, 49, zwischen denen in Axialrichtung eine definierte Widerstandsstrecke 47′ hergestellt ist. Das Widerstandsmaterial des Belages 47 ist dabei so beschaffen, daß der ohmsche Widerstand in axialem Abstand zwischen den beiden Schleifkontakten 48, 49 abhängig ist vom Drehwinkel φ. In der Stellung φ = 0, d. h. zu Beginn der Schicht, ist der Widerstand am kleinsten. Er steigt stetig an bis zu dem Drehwinkel φₘₐₓ.

Darüber hinaus sind an beiden Stirnseiten 50, 51 Widerstandsbeläge 54, 55 in Form eines in Radiusrichtung gleichbreiten Kreissegmentes (Lücke bei 46′) aufgebracht, wobei Schleifkontakte 52, 52′ bzw. 53, 53′ jeweils im Bereich des Innen- und Außenrandes der Widerstandsbeläge 54 bzw. 55 kontaktieren. Auch die Widerstandsbeläge 54 und 55 sind derart beschaffen, daß in Radiusrichtung der ohmsche Widerstand bei verschiedenen Stellungen der Trommel proportional zum Drehwinkel φ ist. Der Widerstand zwischen den Schleifkontakte 52 - 52′ und 53 - 53′ kann daher stetig und kontinuierlich geändert werden, ohne daß die Länge der Widerstandsstrecke 54′ bzw. 55′ geändert wird.

Figur 6 zeigt ein Ersatzschaltbild für das Dämpfungsglied gemäß Figuren 4 und 5. Die entsprechenden Kontakte und Positionen sind durch gleiche Ziffern bezeichnet.

Die Schleifkontakte 52, 52′ und 53, 53′ sind in ähnlicher Weise mit Kontaktträgern verbunden, die in Lötfahnen enden, wie dies auch anhand der Figuren 1 und 2 beschrieben worden ist. Die Verstellung der Trommel 18 erfolgt in diesem Falle durch einen Schlitz, der in einen Achsstummel 56 eingelassen worden ist.

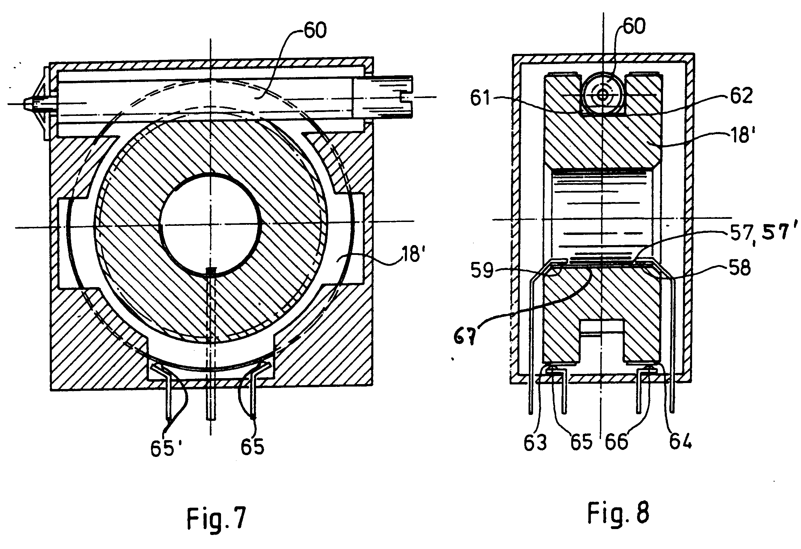

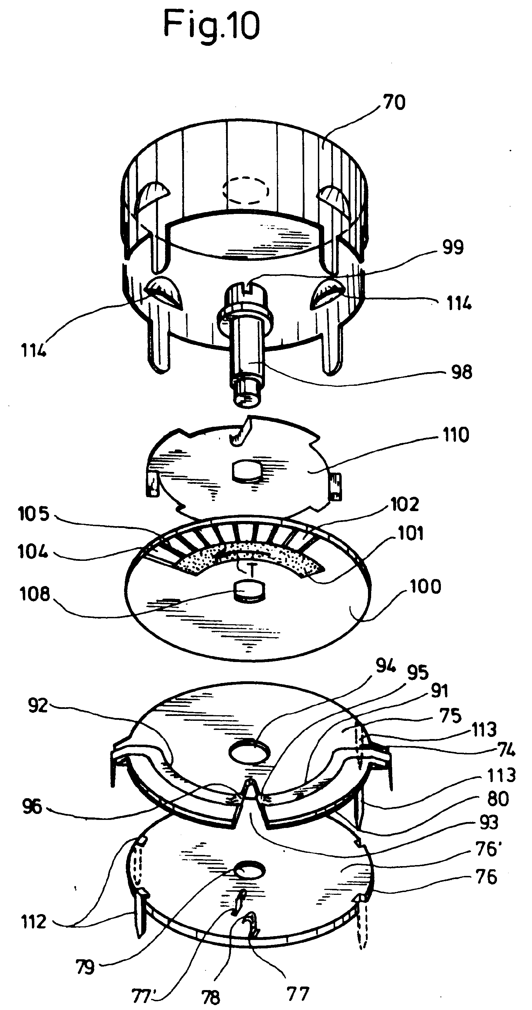

Die Figuren 7 und 8 zeigen eine weitere Möglichkeit zur Ausführung eines Dämpfungsgliedes. In diesem Falle ist ein Widerstandsbelag 57 im Innenmantel 67 einer Hohltrommel 18′ aufgebracht, Zwei Schleifkontakte 58, 59 liegen im Randbereich dieses Widerstandsbelages 57. Zwischen den Schleifkontakten 58, 59 liegt eine Widerstandsstrecke 57′.

Die Trommel 18′ ist drehbar durch eine Schneckenspindel 60, die sich innerhalb eines in eine Ringnut 61 eingelassenen Zahnkranzes 62 dreht und damit die Trommel 18′ antreibt. Auf dem Außenmantel der Trommel 18′ sind in zwei elektrisch getrennten Streifen zwei weitere Widerstandsbeläge 63, 64 aufgebracht, die durch entsprechende Schleifkontakte 65, 66 kontaktiert werden. Ähnlich wie bei der Ausführungsform gemäß Figur 1, 2 befinden sich weitere Schleifkontakte 65′ (ein weiterer ist verdeckt) in einem Winkelabstand voneinander, so daß bei entsprechender Beschaffenheit der Widerstandsbeläge ein kontinuierlich änderbarer Widerstand bei gleicher Widerstandsstrecke zwischen den Schleifkontakten hergestellt werden kann.

Der Abstand der Schleifkontakte auf den außerhalb (peripher) oder innerhalb im Mantel (epipher) liegenden Widerstandsschichten liegt etwa zwischen 10 und 45°. Hier muß ein Kompromiß zwischen der Genauigkeit des Widerstandes und der Breite der Variation gefunden werden, wobei die Auswahl auch von der Größe des Drehkörpers und Dämpfungsgliedes insgesamt abhängt. Die Widerstandswerte zwischen den Schleifkontakten variieren entsprechend den Notwendigkeiten und Gegebenheiten für derartige Dämpfungsschaltungen. Geeignete Werte wurden bereits in der Beschreibungseinleitung diskutiert.

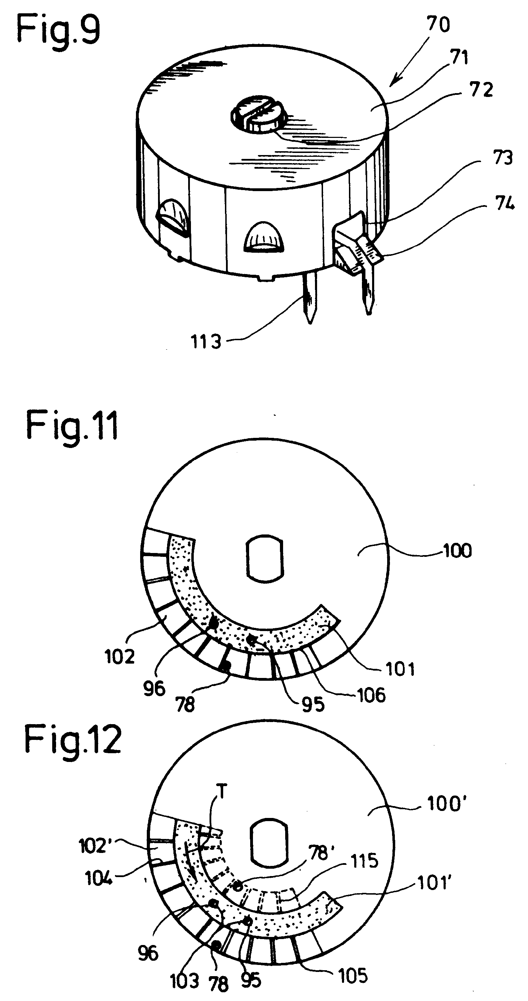

In den Figuren 9 bis 11 ist eine weitere Ausführungsform dargestellt, die sich in der Praxis als besonders geeignet herausgestellt hat. In einem zylindrischen Gehäuse 70 gemäß Figur 9 befinden sich die Teile, die in auseinandergezogener Darstellung in der Figur 10 gezeichnet sind. Das Gehäuse 70 besteht aus Kunststoff, der an seiner Oberfläche metallisiert ist, oder aber aus einem Metallblech. Das Gehäuse 70 ist in seinem Deckel 71 mit einem kreisrunden Achsdurchtritt 72 versehen. An den gegenüberliegenden Seiten des Gehäuses sind Einschnitte 73 vorgesehen, aus denen Zungen 74 eines noch zu beschreibenden Basisteils 75 herausragen.

In Figur 10 ist ein in das Gehäuse 70 eingesetzter Boden 76 zu erkennen, der aus zwei Schichten besteht: aus einem nicht-leitendem Kunststoffmaterial und aus einer aufliegenden Metallschicht 76′. Es ist jedoch auch möglich, den Boden insgesamt aus Metallblech herzustellen. Der Boden 76 ist in das Gehäuse 70 eingepaßt, beispielsweise eingeschweißt oder eingeklebt. Auf den Boden 76 ist unter Herstellung einer elektrischen Verbindung mit der Metallschicht 76′ eine Kontaktfahne 77 fest aufgesetzt. Nach oben ist die Kontaktfahne 77 zu einem Schleifkontakt 78 abgebogen. Zusätzlich kann - je nach Ausführungsform und Schaltung - noch eine zweite, gleiche Kontaktfahne 77′ auf den Boden 76 leitend aufgesetzt werden. Diese Kontaktfahne ist sowohl radial als auch tangential zu der Kontaktfahne 77 versetzt, und zwar zum Zentrum des Bodens hin. Das Zentrum des Bodens 76 wird von einer kreisrunden Öffnung 79 eingenommen, die dem Achsdurchtritt 72 des Gehäuses 70 gegenüberliegt. Zwei Lötschwerter 112 sind als Massekontakte am Boden 76 mit der Metallschicht 76′ verbunden.

Mit dem Boden verbunden ist das Basisteil 75, das aus einer Kunststoff-Platte besteht, die auf ihrer Unterseite eine durchgehende Metallschicht 80 trägt. Zwei Lötschwerter 113 sind mit der Metallschicht 80 als Massekontakt verbunden. Von dieser Metallschicht 80 isoliert sind an der Oberseite zwei metallische, streifenförmige Wellenleiter 91, 92 vorgesehen, die eine etwa sichelförmige Gestalt haben, zueinander symmetrisch liegen und je an einer Kante eines in dem Basisteil 75 vorgesehenen Schlitzes 93 enden. An den Kanten des Schlitzes 93 dienen die Wellenleiter 91, 92 als Träger zweier Schleifkontakte 95, 96. Weiterhin ist in dem Basisteil 75 eine zentrale Öffnung 94 als Durchtritt vorgesehen. In den Öffnungen 79, 94 und 72 wird ein geflanschter, konturierter Achsstummel 98 gehalten, der an seiner Oberseite einen Schlitz 99 trägt, über den mittels eines Schraubendrehers ein Drehmoment auf den Achsstummel 98 ausgeübt werden kann.

Der Achsstummel 98 trägt einen Drehkörper 100, der als flache Kreisscheibe gestaltet ist und im wesentlichen aus isolierendem Kunststoff besteht. Der Drehkörper 100 ist in der Figur 11 von unten gesehen dargestellt. Der Drehkörper 100 wird auf seiner in Figur 11 dargestellten Unterseite von den beiden Schleifkontakten 95, 96 sowie von dem Schleifkontakt 78 berührt. Diese Berührungsstellen sind mit Punkten und einer entsprechenden Numerierung in der Figur 11 bezeichnet.

Der Drehkörper 100 ist mit einer Zentralbohrung 108 versehen, wobei über eine entsprechende Kontur die Drehung mittels Achsstummel 98 bewirkt werden kann. Um das eingebaute System zu stabilisieren, ist weiterhin eine Federscheibe 110 eingebaut. Ein weiteres Widerlager bilden die am Gehäuse nach innen einspringenden Absätze 114.

Der Drehkörper 100 trägt auf seiner Unterseite zwei einander kontaktierende segmentartige Widerstandsbeläge 101 und 102. Der Widerstandbelag 101 besteht aus einer kontinuierlichen Schicht, die jedoch in Tangential-Richtung T einen kontinuierlich ansteigenden Widerstandskoeffizienten aufweist. Die zwischen den beiden Kontakten 95 und 96 befindliche Widerstandsstrecke 103 hat demnach einen unterschiedlichen Wert je nach Stellung des Drehkörpers 100. Im Bereich des Widerstandbelages 102 ist diese Anordnung anders gewählt. Hier sind einzelne Widerstandsstrecken in Form paralleler Streifen 104 aufgebracht, zwischen denen nicht-leitende Zonen 105 liegen.

Die nichtleitenden Zonen 105 sind wesentlich schmaler als die Streifen 104; erstere werden aus einem kontinuierlichen Belag z.B. durch Laserstrahlen herausgebrannt. Jeder Streifen 104 hat, gemessen von Anfang bis Ende, einen höheren bzw. niedrigeren Wert als sein Nachbarstreifen. Demnach ist der Widerstand, der zwischen dem Kontakt 78 und dem Berührungsbereich 106 zwischen den beiden Widerstandsbelägen 101 und 102 besteht, je nach Stellung des Drehkörpers 100, verschieden. Die beiden Widerstandszonen 101 und 102 stehen demnach miteinander in Kontakt in den Bereichen, in denen die Streifen 104 den Widerstandsstreifen 101 berühren.

Demnach läßt sich in einfacher Weise eine T-Schaltung mit Hilfe des in den Figuren 9 - 11 dargestellten Dämpfungsgliedes erreichen. Durch entsprechende Anordnung der Kontakte lassen sich auch π-Schaltungen verwirklichen.

Darüber hinaus ist es möglich, den Basisteil 75 gegenüber dem Boden 76 so anzuordnen, daß eine leichte Verdrehbarkeit dieser beiden Teile zueinander gegeben ist. Diese Verdrehbarkeit kann ermöglichen, daß eine symmetrische Dämpfung genau einjustiert werden kann. Einzelheiten der Drehbarkeit sind nicht gezeichnet, da verschiedene Möglichkeiten einer technischen Durchführung bestehen.

Ein besonderer Vorteil ist, daß die Schleifkontakte 95, 96 sich an den Enden zweier Wellenleiter befinden, die in Streifenleitungstechnik angebracht worden sind. Hierdurch läßt sich die Herstellung von Dämpfungsgliedern, in denen Wellenleiter enthalten sind, wesentlich rationalisieren.

Figur 12 schließlich zeigt eine Ausführungsmöglichkeit des Drehkörpers, Bezugszahl 100′, bei der drei einander kontaktierende, segmentartige Widerstandsbeläge 101′, 102′ und 115 in Form von Kreissegmenten nebeneinanderliegen. Durch entsprechende Verteilung von Kontakten, insbesondere durch den weiteren Schleifkontakt 78′, der die innerste Schicht 115 kontaktiert, kann hierbei erreicht werden, daß die Dämpfungssymmetrie noch besser einstellbar ist. Durch einfaches Versetzen der Schleifkontakte läßt sich über die dritte Schicht der erforderliche Widerstandswert besser korrigieren.

## Patentansprüche

1. Verstellbares Dämpfungsglied mit einem vorgegebenen eingangs- und ausgangsseitig konstanten Wellenwiderstand, mit dem die Durchgangsdämpfung stetig zwischen einem Anfangs- und Endwert einstellbar ist, mit wenigstens zwei gleichzeitig verstellbaren, ohmschen Widerständen, die in unsymmetrischer oder symmetrischer π-, T- oder überbrückter T-Schaltung angeordnet sind,
bei dem Schleifkontakte (29, 30; 41, 42; 48, 49; 52, 52′, 53, 53′; 58, 59; 65, 66, 65′; 78, 78′, 95, 96) auf einem Drehkörper (18; 18′; 100) aufliegen, der gegenüber den Schleifkontakten (29, 30; 41, 42; 48, 49; 52, 52′, 53, 53′; 58, 59; 65, 66, 65′; 78, 78′, 95, 96) entsprechend zwischen Φₒ und Φₘₐₓ liegendem Drehwinkel Φ mechanisch verdrehbar ist und im Schleifbereich wenigstens zwei Widerstandsbeläge (26; 39; 47; 54; 55; 57; 63; 64; 67; 101; 102; 115) aufweist,
die aus einer Beschichtung gebildet sind und auf wenigstens einer Fläche (25; 50; 51; 67; 38) des Drehkörpers (18; 18′; 100) aufgebracht sind,
auf denen zwei Schleifkontakte (41, 42; 48, 49; 58, 59; 95, 96) paarweise in konstantem peripherem bzw. epipherem bzw. axialem Abstand aufliegen, zwischen denen sich eine immer gleichlange Widerstandsstrecke (26′, 39′, 47′, 57′) befindet und keiner der Schleifkontakte (29, 30: 41, 42; 48, 49; 52, 52′, 53, 53′; 58, 59; 65, 66, 65′; 78, 78′, 95, 96) sich ständig auf einer Widerstandsstrecke (26′, 39′, 47′, 57′) befindet, die einen vernachlässigbar kleinen spezifischen Widerstand hat,
wobei der Widerstandsbelag (39; 47; 67; 101) so beschaffen ist, daß der ohmsche Widerstand pro Streckeneinheit des Widerstandsbelags in peripherem bzw. epipherem bzw. axialem Abstand abhängig vom Drehwinkel Φ unterschiedlich festgelegt ist.

2. Dämpfungsglied nach Anspruch 1, dadurch gekennzeichnet, daß der Drehkörper als eine Trommel (18; 18′), in bekannter Weise als Scheibe (Drehkörper 100) oder als Scheibenanordnung ausgebildet ist.

3. Dämpfungsglied nach Anspruch 1 und 2, dadurch gekennzeichnet, daß der Winkelabstand der zwei Schleifkontakte (41, 42; 58, 59; 95, 96), die peripher oder epipher auf einem Kreis-Segment-Widerstandsbelag aufliegen, zwischen 10 und 45° liegt.

4. Dämpfungsglied nach wenigstens einem der Ansprüche 1 bis 3, dadurch gekennzeichnet, daß die Schleifkontakte (41, 42; 48, 49; 58, 59; 95, 96) an zugehörigen Kontaktträgern (43, 44; 91, 92) liegen, die als Wellenleiter dienen.

5. Dämpfungsglied nach einem der vorhergehenden Ansprüche, mit einem den Drehkörper umschließenden, vorzugsweise quaderförmigen Gehäuse (11), dadurch gekennzeichnet, daß die Kontaktträger (43, 44) der Schleifkontakte (41, 42) in einer Gehäusewand gehalten ist.

6. Dämpfungsglied nach wenigstens einem der vorhergehenden Ansprüche, mit einem den Drehkörper umschließenden, vorzugsweise runden Gehäuse (70), dadurch gekennzeichnet, daß die Schleifkontakte (95; 96) von einem Wellenleiter (91; 92) gehalten sind.

7. Dämpfungsglied nach einem der vorhergehenden Ansprüche, mit einem den Drehkörper (18, 18′; 100) umschließenden Gehäuse (11; 70), dadurch gekennzeichnet, daß wenigstens ein Achsstummel (16, 17, 98) in einer Öffnung des Gehäuses (11; 70) drehbar gehalten sind.

8. Dämpfungsglied nach einem der vorhergehenden Ansprüche, dadurch gekennzeichnet, daß ein Basisteil (75), das aus einer Kunststoffplatte besteht, die auf ihrer Unterseite eine durchgehende Metallschicht (80) mit zwei als Massekontakt dienenden Lötschwertern (113) trägt und auf deren Oberseite die zwei Wellenleiter (91, 92) vorgesehen sind, gegenüber dem Boden (76) zur Einstellung der Dämpfungssymmetrie um einen begrenzten Drehwinkel verdrehbar ist.

## Claims

1. Adjustable attenuator with a predetermined input and output-side constant surge impedance, with which the throughput attenuation is constantly adjustable between a starting and an end value, having at least two simultaneously displaceable ohmic resistances, which are disposed in an asymmetrical or symmetrical π-, T or bridged T-circuit,
in which sliding contacts (29, 30; 41, 42; 48, 49; 52, 52′, 53, 53′; 58, 59; 65, 66, 65′; 78, 78′, 95, 96) rest on a rotary body (18; 18′; 100), which is mechanically rotatable relative to the sliding contacts (29, 30; 41, 42; 48, 49; 52, 52′, 53, 53′; 58, 59; 65, 66, 65′; 78, 78′, 95, 96) corresponding to an angle of rotation Φ between Φₒ and Φₘₐₓ and has in the sliding region at least two resistance layers (26; 39; 47; 54; 55; 57; 63; 64; 67; 101; 102; 115),
which are formed from a coating and are applied to at least one surface (25; 50; 51; 67; 38) of the rotary body (18; 18′; 100), on which two sliding contacts (41, 42; 48, 49; 58, 59; 95, 96) rest in pairs with a constant peripheral or epipheral or axial spacing, between which a resistance section (26′, 29′, 47′, 57′) of always the same length is located and none of the sliding contacts (29, 30; 41, 42; 48, 49; 52, 52′, 53, 53′; 58, 59; 65, 66, 65′; 78, 78′, 95, 96) is located constantly on one resistance section (26′, 39′, 47′, 57′) which has a negligibly small specific resistance,
wherein the resistance layer (39; 47; 67; 101) is such that the ohmic resistance per unit length of the resistance layer is fixed differently as a function of the angle of rotation Φ at a peripheral or epipheral or axial distance.

2. Attenuator according to claim 1, characterised in that the rotary body is formed as a drum (18; 18′), in a known manner as a disc (rotary body 100) or as a disc arrangement.

3. Attenuator according to claim 1 and 2, characterised in that the angular distance of the two sliding contacts (41, 42; 58, 59; 95, 96), which rest peripherally or epipherally on a circular segment-shaped resistance layer, is between 10 and 45°.

4. Attenuator according to at least one of claims 1 to 3, characterised in that the sliding contacts (41, 42; 48, 49; 58, 59; 95, 96) rest on associated contact supports (43, 44; 91, 92) acting as waveguides.

5. Attenuator according to one of the preceding claims, having a preferably cuboid housing (11) enclosing the rotary body, characterised in that the contact supports (43, 44) of the sliding contacts (41, 42) are held in a housing wall.

6. Attenuator according to one of the preceding claims, having a preferably round housing (70) enclosing the rotary body, characterised in that the sliding contacts (95; 96) are held by a waveguide (91; 92).

7. Attenuator according to one of the preceding claims, having a housing (11;70) enclosing the rotary body (18, 18′; 100), characterised in that at least one shaft end (16, 17, 98) is/are held rotatably in an aperture in the housing (11; 70).

8. Attenuator according to one of the preceding claims, characterised in that a base member (75), consisting of a plastics plate having on its under-side a continuous metal coating (80) with two solder blades (113) acting as an earth contact and on its upper face the two waveguides (91,92), is rotatable relative to the base (76) through a limited angle of rotation for adjustment of the attenuation symmetry.

## Revendications

1. Atténuateur variable, à impédance caractéristique constante déterminée sur le côté d'entrée et le côté de sortie, qui permet de régler constamment l'amortissement de transmission entre une valeur initiale et une valeur finale, incluant au moins deux résistances ohmiques simultanément variables qui sont disposées sous la forme de circuit asymétrique ou symétrique en π, en T ou en T court-circuité,
dans lequel des curseurs (29, 30; 41, 42; 48, 49; 52, 52′, 53, 53′; 58, 59; 65, 66, 65′; 78, 78′, 95, 96) s'appuient sur un corps rotatif (18; 18′; 100) qui peut être tourné mécaniquement selon un angle de rotation Φ compris entre Φ₀ et Φₘₐₓ par rapport aux curseurs (29, 30; 41, 42; 48, 49; 52, 52′, 53, 53′; 58, 59; 65, 66, 65′; 78, 78′, 95, 96), et qui comporte dans la zone de frottement au moins deux couches minces résistantes (26; 39; 47; 54; 55; 57; 63; 64; 67; 101; 102; 115)
qui sont constituées d'un revêtement et sont appliquées au moins sur une surface (25; 50; 51; 67; 38) du corps rotatif (18; 18′; 100),
sur lesquelles deux curseurs (41, 42; 48, 49; 58, 59; 95, 96), entre lesquels se trouve un trajet résistant qui est toujours de même longueur, s'appuient par paires à distance périphérique ou épiphérique ou axiale constante, aucun des curseurs (29, 30; 41, 42; 48, 49; 52, 52′, 53, 53′; 58, 59; 65, 66, 65'; 78, 78', 95, 96) ne se trouvant constamment sur un trajet résistant (26′, 39′, 47′, 57′) dont la résistance spécifique est faible au point d'être négligeable,
la couche mince résistante (39; 47; 67; 101) étant réalisée d'une manière telle que la résistance ohmique par unité de trajet de la couche mince résistante en distance périphérique ou épiphérique ou axiale est déterminée de façon différente en fonction de l'angle de rotation Φ.

2. Atténuateur selon la revendication 1, caractérisé en ce que le corps rotatif est réalisé sous la forme d'un tambour (18; 18′), de façon connue sous la forme d'un disque (corps rotatif 100) ou sous la forme d'un agencement de disques.

3. Atténuateur selon la revendication 1 et 2, caractérisé en ce que l'écart angulaire entre les deux curseurs (41, 42; 58, 59; 95, 96) qui sont situés sur la périphérie ou l'épiphérie d'une couche mince résistante en forme de segment circulaire est compris entre 10 et 45°.

4. Atténuateur selon l'une au moins des revendications 1 à 3, caractérisé en ce que les curseurs (41, 42; 48, 49; 58, 59; 95, 96) sont situés sur des supports associés (43, 44; 91, 92) de contact qui servent de guides d'ondes.

5. Atténuateur selon l'une des revendications précédentes, comportant un boîtier (11), de préférence parallélépipédique, qui enferme le corps rotatif, caractérisé en ce que les supports (43, 44) de contacts des curseurs (41, 42) sont tenus dans une paroi du boîtier.

6. Atténuateur selon l'une au moins des revendications précédentes, comportant un boîtier (70), de préférence rond, qui enferme le corps rotatif, caractérisé en ce que les curseurs (95; 96) sont tenus par un guide d'ondes (91; 92).

7. Atténuateur selon l'une des revendications précédentes, comportant un boîtier (11; 70) qui enferme le corps rotatif (18, 18′; 100) caractérisé en ce qu'au moins un tourillon (16, 17, 98) est tenu à rotation dans une ouverture du boîtier (11; 70).

8. Atténuateur selon l'une des revendications précédentes, caractérisé en ce qu'une pièce de base (75) qui se compose d'une plaque en matière plastique, portant sur son côté inférieur une couche métallique traversante (80) pourvue de deux lames brasées (113) servant de contact de masse et portant sur le côté supérieur deux guides d'ondes (91, 92), est montée à rotation selon un angle de rotation limité par rapport au fond (76) pour régler la symétrie d'amortissement.
